# EUROPÄISCHE PATENTSCHRIFT

(11) **EP 1 457 099 B1**
(45) Veröffentlichungstag und Bekanntmachung des Hinweises auf die Patenterteilung: **08.06.2005**
(21) Anmeldenummer: 02806025.9
(22) Anmeldetag: 23.12.2002
(51) Int. Cl.: H05K 3/04, H05K 3/20, H01L 21/48

(54) **SYSTEM ZUR FERTIGUNG VON ELEKTRISCHEN UND INTEGRIERTEN SCHALTKREISEN**
SYSTEM FOR THE MANUFACTURE OF ELECTRIC AND INTEGRATED CIRCUITS
SYSTEME DE PRODUCTION DE CIRCUITS DE COMMUTATION ELECTRIQUES ET INTEGRES

(30) Priorität: 14.01.2002 DE 10201091
(43) Veröffentlichungstag der Anmeldung: 15.09.2004
(73) Patentinhaber: Fraunhofer-Gesellschaft zur Förderung der angewandten Forschung e.V., 80636 München (DE)
(72) Erfinder: KÖNIG, Martin, 81475 München (DE); BOCK, Karlheinz, 82110 Germering (DE)
(74) Vertreter: Schoppe, Fritz, Dipl.-Ing.
(86) Internationale Anmeldenummer: PCT/EP2002/014740
(87) Internationale Veröffentlichungsnummer: WO 2003/059026

(56) Entgegenhaltungen:
- WO-A-99/60829
- US-A- 2 776 235
- US-A- 5 800 723
- US-A- 5 826 329

## Beschreibung

Die vorliegende Erfindung bezieht sich auf die Herstellung elektrischer bzw. integrierter Schaltungen, und insbesondere auf Verfahren zur Herstellung von elektrischen bzw. integrierten Schaltungen mit einer Mehrzahl von elektrischen Elementen.

Die Herstellungsprozesse elektrischer Schaltungen und integrierter Schaltungen (ICs = integrated circuits), wie sie z. B. in der Leiterplattentechnik oder der Halbleitertechnik betrieben werden, sind sehr aufwendige und damit teuere Prozesse, wobei dies insbesondere deutlich wird, wenn es sich um die Herstellung kleinerer Stückzahlen oder die Herstellung von Prototypen handelt.

Üblicherweise werden elektrische und integrierte Schaltungen mit aufwendigen lithographischen und nasschemischen Verfahren hergestellt.

Die in der Halbleitertechnologie verwendeten Schichten müssen auf den Halbleiterscheiben (Wafer) in eine Vielzahl von einzelnen Bereichen, z. B. Leiterbahnen, unterteilt werden. Diese Strukturierung erfolgt gegenwärtig fast durchweg mit Hilfe der lithographischen Technik.

Ein wesentliches Merkmal dieser Technik ist eine strahlungsempfindliche Resistschicht, die in den gewünschten Bereichen so bestrahlt wird, dass in einem geeigneten Entwickler nur die bestrahlten (oder nur die unbestrahlten) Bereiche entfernt werden. Das so entstehende Resistmuster dient dann als Maske bei einem darauf folgenden Prozessschritt, z. B. bei einer Ätzung bzw. Nassätzung. Schließlich wird die Resistmaske wieder abgelöst. Die Resistmaske übt somit nur einen vorübergehende Funktion aus, und ist somit nicht Bestandteil der integrierten Schaltung.

Will man nun für die elektrischen bzw. integrierten Schaltungen mehrschichtige Leiterplatten einsetzen, müssen in den Leiterplatten Durchkontaktierungen realisiert werden. Ferner müssen für einen dreidimensionalen Aufbau von integrierten Schaltungen (ICs; IC = integrated circuit) mehrere integrierte Schaltungen übereinander gestapelt werden und durch vertikale Vias (Durchführungslöcher) elektrisch miteinander kontaktiert werden. Diese Durchführungslöcher werden anschließend mit einem leitenden Material aufgefüllt.

Darüber hinaus können zur Erzeugung von Leiterplatten für elektrische und integrierte Schaltungen sogenannte Sputterverfahren mit einem nachfolgenden galvanischen Verfahren zur Schichtdickenerhöhung eingesetzt werden. Die Schichtdickenerhöhung ist bei dem Sputterverfahren notwendig, um den Flächenwiderstand der extrem dünnen Sputterschicht zu verringern.

Bei dem Herstellungsprozess von elektrischen und integrierten Schaltungen wird dieses Leiterbahnsubstrat nun im allgemeinen mit Hilfe von Bestückungsautomaten mit den entsprechenden aktiven Bauelementen (ICs, Dioden, Transistoren) und den entsprechenden passiven Bauelementen (resistiven, kapazitiven, induktiven Bauelementen) bestückt.

Bei der Herstellung elektrischer und integrierter Schaltungen mit den oben erörterten Herstellungsverfahren ergeben sich eine Reihe von Problemen, die insbesondere durch die hohen Anschaffungskosten und den aufwendigen Unterhalt der prozesstechnischen Anlagen bzw. Ausrüstungen und durch die Vielzahl an unterschiedlichen Prozessschritten für die Herstellung der Leiterplatinen und deren Bestückung mit passiven und aktiven Bauelementen deutlich werden. Somit ist es häufig für kleinere Unternehmen finanziell nicht möglich, in einen derart aufwendigen Maschinenpark zum Durchführen der Vielzahl an unterschiedlichen Prozessschritten zu investieren, wobei für die Herstellung von Prototypen oder kleineren Stückzahlen von elektrischen und integrierten Schaltungen der Aufwand generell sehr hoch und damit die Herstellung derselben sehr kostenintensiv ist.

Die wesentlichen Nachteile bei der Herstellung von elektrischen und integrierten Schaltungen mit herkömmlichen Herstellungsprozessen lassen sich daher folgendermaßen zusammenfassen.

Bei dem herkömmlichen Herstellungsverfahren von elektrischen und integrierten Schaltungen müssen eine Vielzahl von unterschiedlichen lithographischen und nasschemischen Prozessen durchlaufen werden. Ferner ist der Bestückungsprozess von Leiterplatten, und insbesondere mehrschichtigen Leiterplatten, mit aktiven und passiven Bauteilen äußerst aufwendig. Darüber hinaus ist die Herstellung dreidimensionaler integrierter Schaltungen äußerst kompliziert und aufwendig, wobei bei den bisherigen Herstellungsverfahren keine sehr hohe dreidimensionale Integrationsdichte, d. h. in der Regel nur mit einem sehr hohen Aufwand und damit mit sehr hohen Kosten, möglich ist.

Ferner können bei den herkömmlichen Herstellungsverfahren im wesentlichen keine stufenlosen Übergänge zwischen den einzelnen Systemkomponenten, d. h. zwischen den aktiven und/oder passiven Bauelementen, den Sensorsystemen, den Leiterplattensystemen, gebildet werden, wobei Klebeflächen vorgesehen werden müssen, um Schichten miteinander zu verbinden.

Ferner wird deutlich, dass mit den im Stand der Technik bekannten Herstellungsverfahren von elektrischen und integrierten Schaltungen eine Planarisierung derselben aufwendig und eine mechanische Flexibilität der Systemkomponenten aufgrund des verwendeten Si-Materials (Si = Silizium) für die passiven und aktiven Bauelemente nicht bzw. nur eingeschränkt innerhalb eines bestimmten Biegeradius von beispielsweise etwa 2 mm gewährleistet ist.

Ferner ist es ungünstigerweise oft erforderlich, die Schaltungssubstrate bei dem Herstellungsverfahren häufig auf verschiedene Maschinen, z. B. eine Lithographie-Anlage, eine Belackeranlage, eine Entwickleranlage, eine Ätz- und Strip-Anlage und Bestückungsanlagen, umzusetzen.

Ferner ist zu beachten, dass bei den herkömmlichen Herstellungsverfahren für jedes neue Platinen- bzw. Leiterplattenlayout ein aufwendiges Lithographie-Verfahren notwendig ist. Daher müssen die bei der Herstellung verwendeten Geräte und Maschinen für jedes neue Platinenlayout programmiert, umgebaut, eingerichtet und eingefahren werden.

Ferner ist es bei den herkömmlichen Herstellungsverfahren von elektrischen und integrierten Schaltungen erforderlich, dass den Maschinen und Geräten eine Vielzahl von unterschiedlichen Medien, z. B. technische Gase, Chemikalien für das Lithographie-Verfahren, Entwickler, Ätz- und Stripmedien (der verbleibende Photolack wird nach dem Ätzen gestript), zugeführt werden. Ferner müssen die bei der Herstellung angefallenen Chemikalien, z. B. schwermetallhaltige Abfälle beim Ätzen, aufwendig entsorgt werden.

Die Patentveröffentlichung WO99/60829A beschreibt beispielsweise ein Verfahren und eine Vorrichtung zum Herstellen elektrischer Leiterbahnen, Schaltungen und Bauelemente und insbesondere einen Drucker, der Leiterbahnen auf Druckmedien für Schaltungsverbindungen, wie z.B. Verbindungen zu integrierten Schaltungschips, bildet. Der Drucker druckt die Leiterbahnen gemäß einer digitalen Darstellung einer gewünschten Leiterbahnstruktur, die mit einem Computersystem erzeugt wird. Dabei umfaßt der Drucker beispielsweise drei Druckköpfe, die in Serie angeordnet sind, und eine Transportanordnung, die die Druckmedien an den Druckköpfen vorbeitransportiert, um leitfähige, dielektrische und/oder ferromagnetische Tinten zu drucken. Bei einem weiteren Ausführungsbeispiel umfaßt der Drucker einen Einzeldruckkopf, der jede der Tinten nacheinander druckt, wobei deutlich wird, daß es mit dieser Druckanordnung lediglich möglich ist, einzelne strikt getrennte Schichten aus unterschiedlichen Materialien nebeneinander, bzw. übereinander zu drucken.

Die Patentschrift US-5,800,723 beschreibt beispielsweise einen Prozeß zum Herstellen einer flexiblen Schaltung unter Verwendung eines Herstellungsprozesses, der ohne die Verwendung einer Photomaske auskommt. Der Prozeß umfaßt die Schritte des Erzeugens eines elektronischen Bildes von Leiterbahnen, die zumindest eine einseitig flexible Schaltung darstellen, und des selektiven thermischen Übertragens eines Harzes entweder auf eine leitfähige Kaschierung oder ein nicht-leitfähiges flexibles Substrat unter der Steuerung der elektronischen Abbildung, um entweder ein Ätzresist oder einen Leiter zu bilden, der die Leiterbahnen definiert. Das flexible Substrat mit einer leitfähigen Kaschierung wird geätzt, um die Leiterbahnen der flexiblen Schaltung zu bilden, die durch das Ätzresistmaterial definiert sind. Daraufhin wird das Ätzresistmaterial entfernt.

Die Patentschrift US-5,826,329 beschreibt beispielsweise ein Verfahren zum Herstellen einer gedruckten Schaltungsplatine unter Verwendung von Thermotransfertechniken. Dabei wird eine elektrisch leitfähige Beschichtung von einem Thermotransferband auf eine nicht-leitfähige Oberfläche einer nicht-leitfähigen Platine übertragen. Das elektrisch leitfähige Material, das auf die Platine übertragen ist, bildet Leiterbahnen auf der nicht-leitfähigen Oberfläche der nicht-leitfähigen Platine, wodurch eine gedruckte Schaltungsplatine bereitgestellt wird.

Die Patentschrift US-2,776,235 beschreibt beispielsweise ein Verfahren zum Drucken von elektrischen Schaltungsabschnitten, wobei ein elektrischer Schaltungsabschnitt gedruckt wird, indem eine auf einer Trägerschicht angeordnete Schicht aus einem schmelzbaren Material für eine elektrische Schaltung mittels eines Werkzeugs, das die Form ausgewählter Abschnitte der elektrischen Schaltung aufweist, von dem Träger auf ein Basissubstrat übertragen und an demselben befestigt wird.

Ausgehend von diesem Stand der Technik besteht die Aufgabe der vorliegenden Erfindung darin, ein verbessertes und vereinfachtes Konzept zur Herstellung einer elektrischen Schaltung zu schaffen.

Diese Aufgabe wird durch ein Verfahren zur Herstellung einer elektrischen Schaltung gemäß Anspruch 1 und durch eine Vorrichtung zur Herstellung einer elektrischen Schaltung gemäß Anspruch 15 gelöst.

Bei dem erfindungsgemäßen Verfahren zur Herstellung einer elektrischen Schaltung wird ein Substrat zu einer Transferdruckeinrichtung zugeführt. Ferner wird ein mit einem Material versehener Träger zwischen die Transferdruckeinrichtung und das Substrat zugeführt, wobei das Material ein elektrisch funktionales Polymermaterial aufweist. Anschließend wird zumindest ein Teil des Materials von dem Träger auf das Substrat mittels der Transferdruckeinrichtung übertragen, woraufhin das übertragende Material an dem Substrat fixiert wird, um das elektrische Element in Form einer definierten Struktur aus fixiertem Material zu erhalten.

Der vorliegenden Erfindung liegt nun die Erkenntnis zugrunde, mit einem sog. Transferdruckverfahren, wie z. B. einem Thermotransfer- oder Thermosublimations-Druckverfahren, sowohl aktive und/oder passive elektrische Schaltungselemente auf ein Substrat vorzugsweise schichtweise aufzubringen, wobei anstelle der üblicherweise auf einer Trägerfolie angeordneten Farb- bzw. Farbpigment-Materialien geeignete Polymermaterialien, bzw. Materialien, die elektrisch funktionale Polymermaterialien aufweisen, verwendet werden. Die aktiven und/oder passiven elektrischen Schaltungselemente können sowohl bauteiltragende Leiterbahnen oder Platinen als auch passive und aktive, diskrete oder integrierte, elektrische bzw. elektronische Komponenten, wie resistive Elemente, kapazitive Elemente oder induktive Elemente, Dioden, Transistoren, Sensoren oder optische Bauelemente, oder integrierte elektrische Schaltkreise, Aktuatoren, Empfänger- /Sendereinrichtungen, drahtlose Kommunikationssysteme und Kombinationen derselben aufweisen.

Das jeweilige Transferdruckverfahren, d. h. beispielsweise das Thermotransfer- oder PolymersublimationsDruckverfahren, entscheidet darüber, wie ein Polymermaterial und ein Substrat, z. B. Papier, miteinander verbunden werden können. Es gibt im wesentlichen zwei hauptsächliche Wege, wobei einerseits das (elektrisch) funktionale Polymermaterial auf die Oberfläche des Substrats aufgebracht werden kann oder andererseits das Polymermaterial in eine Empfangsschicht (das Substrat) eindringen, d.h. sublimieren, kann. Mit einer geeigneten Nachbehandlung, z. B. mit Wärme, Druck, Laminate, usw. kann die Haftung bzw. Fixierung zwischen dem Polymermaterial und dem Substrat und die Haltbarkeit der Fixierung verbessert werden. Die Art der Verbindung zwischen dem Polymermaterial und dem Substrat ist dabei entscheidend für die mechanische Haltbarkeit des aus einem elektrisch funktionalen Polymermaterial gebildeten elektrischen Schaltungselements auf dem Substrat.

Das halbleitende, leitende oder nicht-leitende Polymermaterial wird beispielsweise mittels eines Heizstempels oder einer Heizzeile einer Thermotransferdruckeinrichtung auf das Substratmaterial, z. B. eine Folie, übertragen. Das Polymermaterial selbst ist entweder durch eine thermoaktive Schicht auf der Trägerfolie gebunden oder ist selbst aufschmelzbar und kann so auf die Substratoberfläche übertragen werden.

Im einfachsten Fall wird das übertragende Polymermaterial auf einer Oberfläche nur mit einer Klebstoffschicht beschichtet (vgl. beispielsweise Pritt-Roller, Scotch-3M-Kleberoller oder PostIt). Das Polymermaterial kann dann mit der Klebstoffschicht auf dem Substratmaterial anhaften und definierte Strukturen aus elektrisch funktionalen Polymermaterialien auf dem Substrat bilden, ohne einen Temperaturschritt verwenden zu müssen. Mit einem "temperaturlosen" Übertragungsprozess können auch temperaturempfindliche Polymersubstanzen verarbeitet werden.

Das erfindungsgemäße Transferdruckverfahren deckt mit den obengenannten Vorgehensweisen eine Vielfalt von druckbaren Polymermaterialien und Polymermaterialmischungen ab. Als Beispiele für druckbare Polymermaterialien sind folgende Materialien zu erwähnen, z. B. halbleitende Polymermaterialien, die Pentacene, Fullerene, Polyhexylthiophene, in intrinsisch leitende Polymermaterialien, wie Silberleitklebstoffe, Baytron, Pedot, wobei ebenfalls Mischungen aus verschiedenen Polymermaterialien bzw. Polymermaterialzusammensetzungen verarbeitet werden können.

Elektrisch funktionale Polymermaterialien können nun erfindungsgemäß ohne einen großen Aufwand mit Hilfe eines auf einem Transferdruckverfahren, z. B. Thermotransfer- oder Thermosublimations-Druckverfahren, basierenden Fertigungsverfahren auf ein geeignetes Substrat aufgebracht werden und die herkömmliche Leiterplatten- und Halbleiterherstellungstechnik ersetzen.

Das erfindungsgemäße Herstellungs- bzw. Transferdruckverfahren ist dabei nicht nur auf die Herstellung von elektrischen Elementen im zweidimensionalen Raum beschränkt. Mit dem erfindungsgemäßen Druckverfahren ist es ferner möglich, mehrere elektrische Schichten aneienander angrenzend oder (vertikal) übereinander zu drucken und gleichzeitig elektrisch, z. B. leitend, miteinander zu vernetzen. Ein Schlagwort hierfür ist die vertikale Systemintegration, bei der die sonst übliche zweidimensionale Ausbreitungsrichtung der elektrischen Schaltung und der integrierten Schaltkreise auf die dritte Dimension vertikal erweitert wird und eine beliebige dreidimensionale Ausbreitung der elektronischen Schaltung mit beliebiger räumlicher Form oder Richtung erreicht wird.

Mit dem erfindungsgemäß eingesetzten Transferdruckverfahren ist es darüber hinaus möglich, einen stufenlosen Übergang in jeder Richtung, beispielsweise auch in vertikaler Richtung, vorzusehen, bei dem z. B. ein Widerstand nicht horizontal angeordnet ist, sondern beispielsweise vertikal aufgebaut ist und so zwei horizontal angeordnete, elektrische Schichten elektrisch leitend miteinander verbinden kann.

Das angesprochene Beispiel mit einem vertikal angeordneten Widerstand ist beliebig auf alle aktiven und passiven Bauteile, wie Widerstände, Kapazitäten, Induktivitäten, Dioden, Transistoren, Sensoren usw., erweiterbar. Somit ist mit der vorliegenden Erfindung die Realisierung vollständig integrierter Systemlösungen möglich.

Das erfindungsgemäße Verfahren zum Aufbringen und Fixieren der elektrisch funktionalen, d. h. beispielsweise leitenden oder halbleitenden, Polymermaterialien an einem Substrat ist mit allen unter den Begriff "Transferdruckverfahren" fallenden Herstellungs- bzw. Druckvorgängen bei einem Thermotransfer- oder Thermosublimations-Drucker kompatibel, wodurch die aufwendigen lithographischen und nasschemischen Herstellungsprozesse von elektrischen Schaltungen vollständig entfallen können.

Die verschiedenen Transferdruckverfahren zur Herstellung elektrischer Schaltungen und integrierter Schaltkreise sind sowohl für eine kostengünstige Rolle-zu-Rolle-Massenfertigung als auch für diskontinuierliche Sheet-Anwendungen (Einzelblatt) geeignet, so dass diese Druckverfahren problemlos ausführbar und miteinander kombinierbar sind.

Ein mögliches elektrisch funktionales Polymermaterial ist beispielsweise das intrinsisch leitende Pentacen, dessen Schmelzpunkt bei ca. 190°C liegt, oder auch das Poly3-Hexylthiophen, das einen Schmelzpunkt von etwa 230°C aufweist. Der spezifische Widerstand des Pentacen-Materials ist dabei nur geringfügig größer, etwa um den Faktor 10, als der spezifische Widerstand von Kupfer. Als ein geeignetes Substrat bzw. Substratmaterial können je nach Anwendungsbereich alle festen und/oder flexiblen Substratmaterialien, wie z. B. Kunststofffolien, Metallfolien, flexible Glasfasersubstrate, Textilmaterialien, Karton oder auch Papier, eingesetzt werden.

Betrachtet man nun beispielsweise die Anwendung eines Thermotransfer- oder Thermosublimationsdruckers genauer, bei denen beispielsweise mit mehreren verschiedenen Grundfarben gedruckt wird, d. h. beispielsweise bei vier Grundfarben mit Cyan, Magenta, Gelb und Schwarz, können anstelle der üblichen Farb- bzw. Farbpigmentmaterialien für die Grundfarben beispielsweise mehrere Polymermaterialien oder Polymerschichten mit einer unterschiedlichen elektrischen Funktionalität aufeinander und/oder aneinander angrenzend gedruckt werden, so dass beispielsweise eine aktive, dreidimensionale Schaltung mit integrierten Schaltungselementen in beliebiger Form erzeugt werden kann, wobei die Schaltungselemente beliebig miteinander vernetzt sein können.

So können beispielsweise Materialien wie Polythiophene, Fullarene, Polyanilin und viele weitere Polymermaterialien verarbeitet werden. Die elektrische Funktionalität bzw. die Schaltungsdichte ist dabei von der Auflösung des jeweils verwendeten Druckers und dessen Druckverfahren abhängig und wird beispielsweise in dpi (dpi = dots per inch = Punkte pro Zoll) angegeben.

Somit kann also festgestellt werden, dass für das Verfahren zur Herstellung von elektrischen und integrierten elektrischen Schaltungen mittels eines Thermotransfer- oder Polymersublimations-Drucker keine aufwendigen Masken oder eine Planfilmtechnik benötigt werden. Die Schaltungen können dabei direkt über ein CAD-Programm (CAD = computer aided design = computerunterstützter Entwurf) oder über ein Programm zur Generierung elektrischer Schaltungen dreidimensional auf einer sog. "Transferdruckeinrichtung" umgesetzt werden.

Vergleicht man die Anschaffungskosten und Betriebskosten von herkömmlichen prozesstechnischen Anlagen und beispielsweise einem Thermotransfer- oder Polymersublimations-Drucker, mit dem das erfindungsgemäße Verfahren zur Herstellung einer elektrischen Schaltung durchgeführt werden kann, so wird deutlich, dass bei einem Thermotransfer- oder Polymersublimations-Drucker, mit dem man elektrisch funktionale Polymermaterialien auf ein Substrat aufbringen, auf demselben fixieren und dreidimensional zu einem System integrieren kann, die Anschaffungs- und Unterhaltskosten äußerst gering sind, wobei zu beachten ist, dass eine Umstellung auf ein neues Schaltungslayout bzw. eine neue Schaltungsanordnung äußerst einfach und schnell durchgeführt werden kann.

Dies gilt natürlich auch für alle anderen unter den Begriff Transferdruckverfahren fallenden Herstellungsverfahren, mit denen das erfindungsgemäße Verfahren zur Herstellung einer elektrischen Schaltung durchgeführt werden kann.

Bevorzugte Ausführungsbeispiele der vorliegenden Erfindung werden nachfolgend unter Bezugnahme auf die beiliegenden Zeichnungen näher erläutert. Es zeigen:
- Fig. 1: eine Prinzipdarstellung des Verfahrens zur Herstellung einer elektrischen Schaltung mittels eines Thermotransferduckeinrichtung gemäß einem ersten bevorzugten Ausführungsbeispiel der vorliegenden Erfindung; und
- Fig. 2: einen beispielhaften Trägerfolienaufbau für einen sog. temperaturlosen Transferdruck gemäß einem weiteren Ausführungsbeispiel der vorliegenden Erfindung.

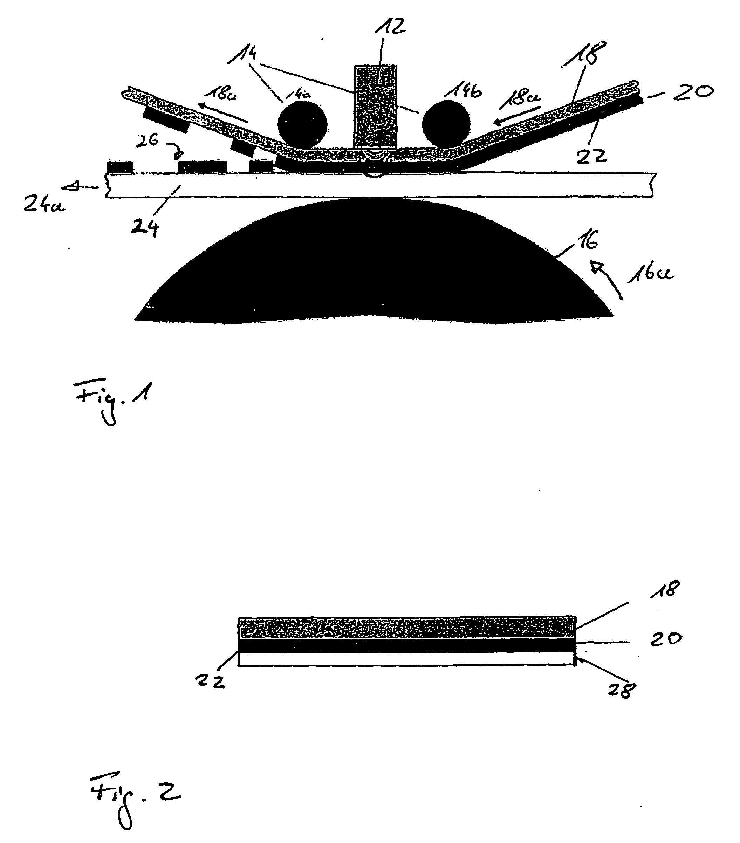

Im folgenden wird nun Bezug nehmend auf die Fig. 1 ein erstes bevorzugtes Ausführungsbeispiel des erfindungsgemäßen Verfahrens zur Herstellung einer elektrischen Schaltung mittels einer Thermotransferdruckeinrichtung beispielhaft erläutert.

Fig. 1 zeigt in einer Prinzipdarstellung wesentliche Bestandteile einer Thermotransferdruckeinrichtung 10 zum Aufbringen eines elektrisch funktionalen Polymermaterials auf ein Substrat, um eine elektrische Schaltung herzustellen.

Unter elektrisch funktionale Materialien (FMs) sind im Rahmen der vorliegenden Erfindung vorzugsweise Polymermaterialien zu verstehen, die durch physikalische und/oder chemische Anregung elektrische, chemische, optische, mechanische oder anderweitige physikalische Aktivität aufweisen können, wobei die verwendeten, elektrisch funktionale Polymermaterialien als Basismaterial für den Aufbau beispielsweise von Sensoren, Aktuatoren, optischen Bauelementen (Sender-Empfänger), elektrischen und integrierten Schaltkreisen, optisch bzw. elektrisch aktiven Verbindungselementen dienen.

Die Thermotransferdruckeinrichtung 10 von Fig. 1 umfasst einen Thermodruckkopf 12, der üblicherweise aus einer Zeile von Heizelementen besteht. Die Thermotransferdruckeinrichtung 10 umfasst ferner eine Führungseinrichtung 14, die aus einer ersten Führungsrolle 14a und einer zweiten Führungsrolle 14b besteht. Gegenüberliegend zu dem Thermodruckkopf 12 ist eine Druckwalze 16 angeordnet. Zwischen dem Thermodruckkopf 12 und der Führungseinrichtung 14 auf der einen Seite und der Druckwalze 16 auf der gegenüberliegenden Seite wird eine Trägerfolie 18 zugeführt, auf der sich eine temperaturaktive Schicht 20, z. B. eine Wachsschicht, mit darin angeordneten elektrisch funktionalen Polymerpartikeln 22 befindet. Der Pfeil 18a gibt dabei die Zuführrichtung der Trägerfolie 18 an. Zwischen der temperaturaktiven Schicht 20 mit den Polymerpartikeln 22 auf der Trägerfolie 18 und der Druckwalze 16 wird ferner gleichzeitig ein Druckmedium 24, z. B. ein Blatt Papier, zugeführt, das sich entsprechend dem Pfeil 24a bezüglich der Rotationsrichtung 16a der Rotationswalze 16 und der Bewegungsrichtung 18a der Trägerfolie 18 durch die Thermotransferdruckeinrichtung 10 bewegt.

Im folgenden wird nun anhand der in Fig. 1 dargestellten Thermotransferdruckeinrichtung 10 das erfindungsgemäße Verfahren zur Herstellung eines elektrischen Elements gemäß dem bevorzugten Ausführungsbeispiel der vorliegenden Erfindung detailliert erläutert.

Bei der Thermotransferdruckeinrichtung 10 von Fig. 1 ist das elektrisch funktionale Polymermaterial beispielsweise in Form von elektrisch funktionalen Polymerpartikeln 22 mit einer temperaturaktiven Schicht 20, z. B. einer Wachsschicht, auf der Trägerfolie 18 gebunden und wird über die Heizzeile des Thermodruckkopfs 12 und optional mittels Druck, der über die Druckwalze 16 ausgeübt wird, partiell oder ganzflächig entsprechend der Struktur des herzustellenden elektrischen Elements auf das Druckmedium 24, d. h. die Substratfolie, übertragen.

Dies wird üblicherweise durchgeführt, indem entsprechende Druckpunkte 26 von der auf der Trägerfolie 18 (Thermotransferfolie) aufgebrachten temperaturaktiven Schicht 20, in der sich die elektrisch funktionalen Polymerpartikel 22 befinden, oder die aus einem elektrisch funktionalen Polymermaterial besteht, mittels Wärme und Druck abgeschmolzen und auf das Druckmedium 24 übertragen werden.

Das elektrisch funktionale Polymermaterial 22 ist nun durch Wachs oder eine temperaturaktive (thermoaktive) Schicht 20 auf der Oberfläche des Druckmediums 24, d. h. auf der Trägeroberfläche, gebunden.

Auch mit einer Thermotransferdruckeinrichtung ist es möglich, unter Verwendung des erfindungsgemäßen Transferdruckverfahrens zur Herstellung eines elektrischen Elements einerseits eine einzige elektrisch funktionale Schicht auf das Substrat zu drucken oder andererseits auch mehrere elektrisch funktionale Schichten vertikal übereinander und/oder aneinander angrenzend aufzubringen und gleichzeitig diese elektrisch leitend miteinander zu vernetzen.

Es sollte bei der vorliegenden Erfindung beachtet werden, dass das erfindungsgemäße Verfahren zur Herstellung einer elektrischen Schaltung nicht ausschließlich auf die beispielhaft in Fig. 1 dargestellten Transferdruckverfahren mittels einer Thermotransferdruckeinrichtung beschränkt ist, sondern dass prinzipiell im wesentlichen alle unter den Begriff Transferdruckeinrichtungen fallenden Herstellungsverfahren zum Aufbringen eines elektrisch funktionalen Polymermaterials auf ein Substrat gemäß dem erfindungsgemäßen Verfahren verwendet werden können.

Ein weiteres erfindungsgemäßes Transferdruckverfahren stellt beispielsweise das sogenannte Thermo- bzw. PolymerSublimationsdruckverfahren dar, bei dem die Polymermaterialien vorzugsweise auf einer dünnen Trägerfolie aufgebracht sind. Diese Trägerfolie wird mit der Druckkopfeinrichtung des Polymersublimationsdruckers in einen sehr engen Kontakt gebracht. Soll nun ein farbiger Punkt erzeugt werden, wird der Druckkopf dort für eine relativ kurze Zeitdauer relativ stark erwärmt, beispielsweise auf eine Temperatur von über 200°C. Das auf die dünne Trägerfolie aufgebrachte Polymermaterial verdampft und wandert in die Empfangsschicht des Substratmaterials hinein oder auf deren Oberfläche. Dieser Vorgang kann nacheinander für eine oder mehrere Lagen wiederholt werden.

Die Bildqualität ist dabei völlig photographisch, da dieses Polymersublimationsdruckverfahren als einzige "digitale Drucktechnik" echte Halbtöne erzeugen kann und somit mehrere Mischungskomponenten verschiedener Polymermaterialschichten herstellbar sind. So wandert je nach der Länge des Heizimpulses mehr oder weniger Polymermaterial in oder auf die Empfangsschicht des Substratmaterials. Die erhaltenen Strukturen, die elektrisch funktionale Schaltungselemente aufweisen können, sind mechanisch sehr robust, da die elektrisch funktionalen Polymermaterialien in der Empfangsschicht des Substratmaterials teilweise oder vollständig eingedrungen sind.

Auf eine ähnliche Weise zu dem obigen Farbsublimationsdruckverfahren wird bei dem bereits ausführlich Thermotransferdruckverfahren eine mit einem Polymermaterial beschichtete Trägerfolie an einem Heizkopf vorbeigeführt.

Durch das Heizen des Heizkopfes löst sich ein Polymermaterialstückchen von der Größe des Schreibkopfes von der Trägerfolie und wird auf das Empfangssubstratmaterial übertragen. Im Gegensatz zu dem Farbsublimationsdruckverfahren dringt bei dem Thermotransferdruckverfahren das Polymermaterial nicht oder nur relativ geringfügig in das Substratmaterial ein. Es handelt sich also nicht um ein Rasterverfahren, sondern um ein Halbtonverfahren. Die Anforderungen an das Polymermaterialband, d.h. die Trägerfolie mit der Polymermaterialbeschichtung, und an das Material der Empfangssubstratschicht sind viel geringer als bei dem Farbsublimationsdruckverfahren.

Bei einem Thermotransferdruckverfahren ist das elektrisch funktionale Polymermaterial beispielsweise mit einer temperaturaktiven Schicht auf einer Trägerfolie gebunden und wird über eine Heizzeile druckpartiell oder ganzflächig auf das Substratmaterial, z. B. eine Substratfolie, übertragen. Anstelle der Heizzeile können auch gravierte oder geätzte Heizstempel verwendet werden, mit denen die Struktur über Druck und/oder Temperatur auf das Substrat übertragen wird.

Mit dem Thermotransferdruck sind beispielsweise Transistorstrukturen herstellbar, wobei mögliche Strukturen für einen Heizstempel bzw. Thermotransfer- oder Thermosublimiations-Drucker Transistorenstrukturen wie Source-, Drain-, und Gate-Anordnungen, Halbleiterstrukturen oder Schaltungsstrukturen, Membrane, Sensorschichten, Aktuatoren, elektrisch aktive und/oder passive und optisch aktive Strukturen sind.

Die vorliegende Erfindung stellt also ein vollkommen neuartiges Konzept für die Fertigung von elektrischen und integrierten Schaltkreisen dar. Mit dem erfindungsgemäßen Transferdruckverfahren können sowohl bauteiltragende Leiterplatinen als auch passive und auch aktive elektrische Komponenten auf ein Substrat gedruckt werden.

Als elektrisch funktionales Polymermaterial können beispielsweise Polythiophene, beschichtete Siliziumpartikel, Fullarene, Polyanilin und andere halbleitende oder leitende Materialien bzw. Kombinationen derselben zum Einsatz kommen.

Für die Passivierung und Gehäusung von elektrisch leitenden oder aktiven Schichten werden beispielsweise Ormocere, Epozeide, Acrylate, Cyanate und deren Modifikationen eingesetzt.

Als Leiterbahnmaterial werden beispielsweise Metallpartikel aufweisende Polymermaterialien, Pentacene oder Polyanilin verwendet, die durch Variation der Schichtdicken oder durch Einstellen der Mengenverhältnisse zwischen der Beschichtung und der leitenden Polymerpartikel auch als passive Bauelemente, wie Widerstände oder Kapazitäten, eingesetzt werden können.

Mit dem Aufbringen und Fixieren von funktionalen Polymermaterialien kann also die Leiterplattenherstellung, deren Bestückungsvorgang und die Herstellung von integrierten Schaltungen (ICs) in einem Gerät vereint werden, um somit integrierte Schaltkreise oder auch integrierte Systemlösungen zu realisieren.

Alle im Zusammenhang der vorliegenden Erfindung aufgeführten Druckverfahren sind sowohl für eine kostengünstige Rolle-zu-Rolle-Fertigung als auch für diskontinuierliche sheet-Anwendungen geeignet. Die Schichtdicken der einzelnen Polymermaterialschichten sind dabei abhängig von dem verwendeten Trägerfolien und darauf angeordneten Polymermaterialen. So sind bei dem ausführlich erläuterten Thermotransferdruckverfahren im allgemeinen sehr geringe Schichtdicken im Bereich etwa ab 1-10nm möglich.

So ist beispielsweise zu beachten, dass bei einem Thermotransferdrucker oder Thermopolymerisationsdrucker über die Erwärmung des Heizelements auf eine relativ einfache Art und Weise die Schichtdicken des aufgebrachten elektrisch funktionalen Polymermaterials variiert werden können. Durch die Verwendung der funktionalen Polymermaterialien können bei der Herstellung des jeweiligen elektrischen Elements die Eigenschaften der Polymermaterialien auf den jeweiligen Verwendungszweck des elektrischen Elements gezielt abgestimmt werden.

Ferner ist es erfindungsgemäß möglich, entweder nur eine einzige Schicht zu drucken oder auch mehrere Schichten übereinander auf das verwendete Substrat zu drucken.

Mit dem vorgestellten Druckverfahren zur Herstellung eines elektrischen Elements gemäß der vorliegenden Erfindung können vollständige elektronische Bauteile mit einer Höhe von beispielsweise mehreren Millimetern hergestellt werden, wobei bei diesen Verfahren elektrische und nicht-elektrische Komponenten parallel, d. h. gleichzeitig, erzeugt werden. So können beispielsweise bei einem Sensor mit dem Thermotransfer- bzw. Thermosublimationsdruckverfahren elektrisch aktive Schichten unter gleichzeitiger Verkapselung derselben hergestellt werden.

Es sollte beachtet werden, dass gemäß dem erfindungsgemäßen Herstellungsverfahren von elektrischen Schaltungen mittels einer Transferdruckeinrichtung auch sog. temperaturlose Transferdruckverfahren eingesetzt werden können, mit denen auch temperaturempfindliche Polymersubstanzen verarbeitet werden können.

In Fig. 2 ist nun beispielhaft ein Trägerfolienaufbau für ein "temperaturloses" Transferdruckverfahren dargestellt, wobei auf einer Trägerfolie 18 eine Materialschicht 20 mit einem elektrisch funktionalen Polymermaterial 22 aufgebracht ist, auf der sich wiederum eine Klebstoffschicht 28 befindet.

Im einfachsten Fall eines erfindungsgemäßen Transferdruckverfahrens wird das zu übertragende Polymaterial 20, 22 auf seiner Oberfläche nur mit einer Klebstoffschicht 28 beschichtet, wobei das zu übertragende Polymermaterial 20, 22 dann mit der Klebstoffschicht 28 auf dem Substratmaterial 24 anhaften, d. h. fixiert werden, kann. Auf diese Weise können definierte Strukturen 26 aus elektrisch funktionalen Polymermaterialien 22 auf dem Substrat 24 gebildet werden, ohne dass dazu ein expliziter Temperaturschritt erforderlich ist. Mit diesem temperaturlosen Übertragungsprozess können auch temperaturempfindliche Polymersubstanzen verarbeitet werden.

Es sollte beachtet werden, dass bei allen erfindungsgemäß einsetzbaren Transferdruckverfahren das Trägermaterial 18 und das Material 20, das das elektrisch funktionale Polymermaterial 22 aufweist, als einzelne Schichten oder auch als eine gemeinsame Schicht ausgeführt sein können. So kann beispielsweise auf einer Trägerfolie 18 eine Schicht aus dem Material 20 mit dem elektrisch funktionalen Polymermaterial 22 aufgebracht sein, wobei beispielsweise nur die Materialschicht 20 strukturiert auf das Substrat 24 übertragen und daran fixiert wird. Es ist aber auch möglich, dass das Trägermaterial 18 und das Material 20 mit dem elektrisch funktionalen Polymermaterial 22 als eine gemeinsame Schicht ausgeführt sind, wobei mit der Transferdruckeinrichtung 12 beispielsweise Teile aus dieser Schicht ausgelöst und auf das Substratmaterial 24 übertragen und dort fixiert werden.

Im Rahmen der vorliegenden Erfindung ist ferner zu beachten, dass die gewünschte elektrische Funktionalität des Polymermaterials beispielsweise auch letztendlich erst durch das Fixieren mittels Wärme und/oder Druck an dem Substrat erreicht werden kann, wenn erst dann die gewünschten elektrischen Effekte der elektrisch funktionalen Polymermaterialien wirksam werden.

Um das "Druckprinzip" zur Herstellung eines elektrischen Elements gemäß der vorliegenden Erfindung zu charakterisieren ist es ferner erforderlich, zwischen der eingesetzten Druckerhardware, also dem technischen Aufbau, d. h. Funktionsprinzip, Papiertransport usw., und der Druckersoftware, die zum Ansteuern des Druckers verwendet wird, dem Druckerbetriebssystem usw. zu differenzieren. Die Software für die Druckeinrichtung dient hierbei zur Steuerung der einzelnen mechanischen Komponenten der Druckeinrichtungen, sowie zur Interpretierung der von einem Computer kommenden Daten, wobei das erfindungsgemäße Verfahren zur Herstellung eines elektrischen Elements unabhängig von der jeweiligen Druckersoftware angewendet werden kann.

## Patentansprüche

1. Verfahren zur Herstellung einer elektrischen Schaltung, mit folgenden Schritten:
Zuführen eines Substrats (24) zu einer Transferdruckeinrichtung (12);
Zuführen eines mit einem Material (20) versehenen Trägers (18) zwischen die Transferdruckeinrichtung (12) und das Substrat (24), wobei das Material (20) ein elektrisch funktionales Polymermaterial (22) aufweist;
Ausüben von Wärme mittels der Transferdruckeinrichtung (12) auf zumindest einen Teil des Materials (20), um zumindest einen Teil des Materials (20) zu verdampfen;
Strukturiertes Übertragen des verdampften Materials (20) auf das Substrat (24); und
Fixieren des strukturiert übertragenden Materials (20) an dem Substrat (24), um eine definierte Struktur (26) aus fixiertem Material zu erhalten.

2. Verfahren nach Anspruch 1, ferner mit folgenden Schritten:
Zuführen eines weiteren mit einem weiteren Material versehenen Trägers zwischen die Transferdruckeinrichtung (12) und das Substrat (24), wobei das weitere Material ein weiteres, elektrisch funktionales Polymermaterial aufweist;
Ausüben von Wärme mittels der Transferdruckeinrichtung auf zumindest einen Teil des weiteren Materials, um zumindest einen Teil des weiteren Materials zu verdampfen;
Strukturiertes Übertragen des weiteren verdampften Materials auf das Substrat (24) mit dem zuvor übertragenen Material; und
Fixieren des strukturiert übertragenen, weiteren Materials an dem Substrat (24) und/oder dem zuvor übertragenen Material, um eine weitere definierte Struktur aus einem weiteren fixiertem Material zu erhalten.

3. Verfahren nach Anspruch 2, ferner mit folgenden Schritt:
Erzeugen einer Mischungskomponente aus dem elektrisch funktionalen Polymermaterial (22) und dem weiteren elektrisch funktionalen Polymermaterial (22).

4. Verfahren nach Anspruch 3, bei dem ein kontinuierlicher Übergang zwischen dem elektrisch funktionalen Polymermaterial (22) und dem weiteren elektrisch funktionalen Polymermaterial (22) erhalten wird.

5. Verfahren nach einem der Ansprüche 2 - 4, bei dem das elektrisch funktionale Polymermaterial (22) und/oder das weitere elektrisch funktionale Polymermaterial (22) in das Substrat (24) wandert.

6. Verfahren nach einem der vorhergehenden Ansprüche, bei dem die Transferdruckeinrichtung (12) eine Thermo-Sublimationsdruckeinrichtung oder eine Polymer-Sublimationsdruckeinrichtung zum Ausüben von Wärme aufweist.

7. Verfahren nach einem der vorhergehenden Ansprüche, bei dem das Material und/oder das weitere Material ein leitendes oder halbleitendes Polymermaterial aufweist.

8. Verfahren nach einem der vorhergehenden Ansprüche, bei dem das elektrisch funktionale Polymermaterial (22) aus einer Gruppe der folgenden Materialien gewählt wird, wobei die Gruppe Pentacen, Polythiophene, Fullarene, Polyanilin, mit Harz oder Klebstoff beschichtete Teilchen aus Metall oder einem Halbleitermaterial, Photopolymere auf Epoxid- und/oder Acrylharzbasis, Polykarbonat, Polystyrol, Nylon oder Feingusswachs, Phthalocyanine, Cupfer(II)Phthalocyanin, Carboxyldiimide, Tetracarboxyldiimid, Poly(3-alkylthiophene, Poly(3-Hexylthiophen)2,5-diyl und Kombinationen derselben umfasst.

9. Verfahren nach einem der vorhergehenden Ansprüche, bei dem die elektrische Schaltung eine Mehrzahl von elektrischen Elementen aufweist.

10. Verfahren nach Anspruch 9, bei dem die elektrischen Elemente untereinander vernetzte elektrische Schaltungselemente sind.

11. Verfahren nach einem der vorhergehenden Ansprüche, bei dem die elektrische Schaltung aus einer Gruppe der folgenden Elemente gewählt wird, wobei die Gruppe Leiterbahnen, Platinen, integrierte Schaltkreise, resistive Elemente, kapazitive Elemente, induktive Elemente, Dioden, Transistoren, Sensoren, Aktuatoren, optische Bauelemente, Empfänger-/Sendereinrichtungen, drahtlose Kommunikationssysteme und Kombinationen desselben aufweist.

12. Verfahren nach einem der vorhergehenden Ansprüche, bei dem das Substrat (24) eine Kunststofffolie, eine Metallfolie, ein flexibles Glasfasersubstrat, Papier, Karton oder ein Textilmaterial oder Kombinationen derselben aufweist.

13. Verfahren nach einem der vorhergehenden Ansprüche, bei dem der Schritt des strukturierten Übertragens eines Materials (20) auf das Substrat (24) den Unterschritt des strukturierten Übertragens einer Schicht des Materials (20) aufweist.

14. Verfahren nach Anspruch 13, bei dem die Schicht eine minimale Dicke im nm-Bereich und vorzugsweise eine Dicke im Bereich von 10 - 100 nm aufweist.

15. Vorrichtung zur Herstellung einer elektrischen Schaltung, mit folgenden Merkmalen :
einer Transferdruckeinrichtung (12);
einer Zuführungseinrichtung, die ausgebildet ist, um ein Substrat (24) zu der Transferdruckeinrichtung (12) zuzuführen; und
einer weiteren Zuführungseinrichtung, die ausgebildet ist, um einen mit einem Material (20) versehenen Träger (18) zwischen die Transferdruckeinrichtung (12) und das Substrat (24) zuzuführen, wobei das Material (20) ein elektrisch funktionales Polymermaterial (22) aufweist;
wobei die Transferdruckeinrichtung (12) ausgebildet ist, um auf zumindest einen Teil des Materials (20) Wärme auszuüben, um zumindest einen Teil des Materials (20) zu verdampfen, um das verdampfte Material (20) auf das Substrat (24) strukturiert zu übertragen, und um das strukturiert übertragene Material (20) an dem Substrat (24) zu fixieren, um eine definierte Struktur (26) aus fixiertem Material zu erhalten.

## Claims

1. A method for producing an electrical circuit, comprising the steps of:
feeding a substrate (24) to transfer printing means (12);
feeding a support (18) provided with a material (20) between the transfer printing means (12) and the substrate (24), the material (20) comprising an electrically functional polymer material (22);
applying heat by means of the transfer printing means (12) to at least a part of the material (20) to evaporate at least a part of the material (20);
transferring the evaporated material (20) onto the substrate (24) in a structured way; and
fixing the material (20) transferred in a structured way to the substrate (24) to obtain a defined structure (26) of fixed material.

2. The method according to claim 1, further comprising the steps of:
feeding another support provided with another material between the transfer printing means (12) and the substrate (24), the other material comprising another electrically functional polymer material;
applying heat by means of the transfer printing means to at least a part of the other material to evaporate at least a part of the other material;
transferring the other evaporated material onto the substrate (24) with the material transferred before in a structured way; and
fixing the other material transferred in a structured way to the substrate (24) and/or the material transferred before to obtain another defined structure of another fixed material.

3. The method according to claim 2, further comprising the step of:
producing a compound of the electrically functional polymer material (22) and the other electrically functional polymer material (22).

4. The method according to claim 3, wherein a continuous transition is obtained between the electrically functional polymer material (22) and the other electrically functional polymer material (22).

5. The method according to one of claims 2 to 4, wherein the electrically functional polymer material (22) and/or the other electrically functional polymer material (22) migrate/s into the substrate (24).

6. The method according to one of the preceding claims, wherein the transfer printing means (12) comprises thermal sublimation printing means or polymer sublimation printing means for applying heat.

7. The method according to one of the preceding claims, wherein the material and/or the other material comprise/s a conducting or semi-conducting polymer material.

8. The method according to one of the preceding claims, wherein the electrically functional polymer material (22) is selected from a group of the following materials, the group including pentacene, polythiophene, fullarene, polyanilin, particles covered by a resin or adhesive, made of a metal or a semiconductor material, epoxy and/or acrylic resin based photopolymers, polycarbonate, polystyrene, nylon, or precision casting wax, phthalocyanine, copper(II)phthalocyanine, carboxyldiimide, tetracarboxyldiimide, poly(3-alkylthiophene, poly(3-hexylthiophene)2,5-diyl, and combinations thereof.

9. The method according to one of the preceding claims, wherein the electrical circuit comprises a plurality of electrical elements.

10. The method according to claim 9, wherein the electrical elements are interconnected electrical circuit elements.

11. The method according to one of the preceding claims, wherein the electrical circuit is selected from a group of the following elements, the group comprising conductive tracks, circuit boards, integrated circuits, resistive elements, capacitive elements, inductive elements, diodes, transistors, sensors, actuators, optical devices, reception/transmission means, wireless communication systems, and combinations thereof.

12. The method according to one of the preceding claims, wherein the substrate (24) comprises a plastic foil, a metal foil, a flexible glass fiber substrate, paper, cardboard, or a textile material, or combinations thereof.

13. The method according to one of the preceding claims, wherein the step of transferring a material (20) onto the substrate (24) in a structured way comprises the sub-step of transferring a layer of the material (20) in a structured way.

14. The method according to claim 13, wherein the layer comprises a minimum thickness in the nm range and, preferably, a thickness in the range from 10 to 100 nm.

15. A device for producing an electrical circuit, comprising:
transfer printing means (12);
feeding means configured to feed a substrate (24) to the transfer printing means (12); and
another feeding means configured to feed a support (18) provided with a material (20) between the transfer printing means (12) and the substrate (24), the material (20) comprising an electrically functional polymer material (22);
wherein the transfer printing means (12) is configured to apply heat to at least a part of the material (20) to evaporate at least a part of the material (20) to transfer the evaporated material (20) onto the substrate (24) in a structured way and to fix the material (20) transferred in a structured way to the substrate (24) to obtain a defined structure (26) of fixed material.

## Revendications

1. Procédé de production d'un circuit électrique, aux étapes suivantes consistant à :
alimenter un substrat (24) vers un dispositif d'impression par transfert (12) ;
alimenter un support (18) pourvu d'un matériau (20) entre le dispositif d'impression par transfert (12) et le substrat (24), le matériau (20) présentant un matériau polymère électriquement fonctionnel (22) ;
exercer de la chaleur au moyen du dispositif d'impression par transfert (12) sur au moins une partie du matériau (20), pour évaporer au moins une partie du matériau (20) ;
transférer de manière structurée le matériau évaporé (20) sur le substrat (24) ; et
fixer le matériau à transférer de manière structurée (20) au substrat (24), pour obtenir une structure définie (26) de matériau fixé.

2. Procédé selon la revendication 1, avec, par ailleurs, les étapes suivantes consistant à :
alimenter un autre support pourvu d'un autre matériau entre le dispositif d'impression par transfert (12) et le substrat (24), l'autre matériau présentant un autre matériau polymère électriquement fonctionnel ;
exercer de la chaleur au moyen du dispositif d'impression par transfert sur au moins une partie de l'autre matériau, pour évaporer au moins une partie de l'autre matériau ;
transférer de manière structurée l'autre matériau évaporé sur le substrat (24) avec le matériel transféré auparavant ; et
fixer l'autre matériau transféré de manière structurée au substrat (24) et/ou au matériau transféré auparavant, pour obtenir une autre structure définie d'un autre matériau fixé.

3. Procédé selon la revendication 2, avec, par ailleurs, l'étape suivante consistant à :
générer un composant de mélange à partir du matériau polymère électriquement fonctionnel (22) et de l'autre matériau polymère électriquement fonctionnel (22).

4. Procédé selon la revendication 3, dans lequel est obtenue une transition continue entre le matériau polymère électriquement fonctionnel (22) et l'autre matériau polymère électriquement fonctionnel (22).

5. Procédé selon l'une des revendications 2 à 4, dans lequel le matériau polymère électriquement fonctionnel (22) et/ou l'autre matériau polymère électriquement fonctionnel (22) passent dans le substrat (24).

6. Procédé selon l'une des revendications précédentes, dans lequel le dispositif d'impression par transfert (12) présente un dispositif d'impression par sublimation thermique ou un dispositif d'impression par sublimation de polymère destiné à exercer de la chaleur.

7. Procédé selon l'une des revendications précédentes, dans lequel le matériau et/ou l'autre matériau présente un matériau polymère conducteur ou semi-conducteur.

8. Procédé selon l'une des revendications précédentes, dans lequel le matériau polymère électriquement fonctionnel (23) est choisi parmi un groupe composé des matériaux suivants, le groupe comprenant le pentacène, les polythiophènes, les fullerènes, la polyaniline, les particules de métal ou d'un matériau semi-conducteur revêtues de résine ou d'adhésif, les photopolymères à base d'époxyde et/ou de résine acrylique, le polycarbonate, le polystyrène, le nylon ou la cire pour coulée fine, les phtalocyanines, la phtalocyanine de cuivre (II), les diimides carboxyliques, les diimides tétracarboxyliques, les poly(3-alkylthiophènes, poly(3-hexylthiophène)2,5-diyl et des combinaisons de ces derniers.

9. Procédé selon l'une des revendications précédentes, dans lequel le circuit électrique présente une pluralité d'éléments électriques.

10. Procédé selon la revendication 9, dans lequel les éléments électriques sont des éléments de circuit électrique réticulés l'un à l'autre.

11. Procédé selon l'une des revendications précédentes, dans lequel le circuit électrique est choisi parmi un groupe des éléments suivants, le groupe présentant des chemins de conducteurs, des plaquettes, des circuits de commutation intégrés, des éléments résistifs, des éléments capacitifs, des éléments inductifs, des diodes, des transistors, des capteurs, des actionneurs, des éléments optiques, des dispositifs récepteurs-transmetteurs, des systèmes de communication sans fil et des combinaisons de ceux-ci.

12. Procédé selon l'une des revendications précédentes, dans lequel le substrat (24) présente un film plastique, un film métallique, un substrat de fibres de verre flexible, du papier, du carton ou un matériau textile ou des combinaisons de ceux-ci.

13. Procédé selon l'une des revendications précédentes, dans lequel l'étape de transfert structuré d'un matériau (20) sur le substrat (24) présente le transfert structuré d'une couche du matériau (20).

14. Procédé selon la revendication 13, dans lequel la couche présente une épaisseur minimale de l'ordre de nm et, de préférence, une épaisseur de l'ordre de 10 à 100 nm.

15. Dispositif de production d'un circuit électrique, aux caractéristiques suivantes :
un dispositif d'impression par transfert (12) ;
un dispositif d'alimentation qui est réalisé de manière à alimenter un substrat (24) vers le dispositif d'impression par transfert (12) ; et
un autre dispositif d'alimentation qui est réalisé de manière à alimenter un support (18) pourvu d'un matériau (20) entre le dispositif d'impression par transfert (12) et le substrat (24), le matériau (20) présentant un matériau polymère électriquement fonctionnel (22) ;
le dispositif d'impression par transfert (12) étant réalisé de manière à exercer de la chaleur sur au moins une partie du matériau (20), pour évaporer au moins une partie du matériau (20), pour transférer de manière structurée le matériau évaporé (20) sur le substrat (24), et pour fixer le matériau (20) transféré de manière structurée au substrat (24), pour obtenir une structure définie (26) de matériau fixé.
